# EUROPEAN PATENT SPECIFICATION

(11) **EP 4 391 741 B1**
(45) Date of publication and mention of the grant of the patent: **25.02.2026**
(21) Application number: 22306993.1
(22) Date of filing: 22.12.2022
(51) Int. Cl.: H05K 3/38, H05K 1/18, H05K 3/42, H05K 3/46, H05K 1/11

(54) **GLASS BARRIER LAYER PRODUCT, AND MANUFACTURE METHOD**
GLASBARRIERESCHICHTPRODUKT UND HERSTELLUNGSVERFAHREN
PRODUIT DE COUCHE BARRIÈRE EN VERRE ET PROCÉDÉ DE FABRICATION

(43) Date of publication of application: 26.06.2024
(73) Proprietor: AT & S Austria Technologie & Systemtechnik Aktiengesellschaft, 8700 Leoben-Hinterberg (AT)
(72) Inventor: Trischler, Heinrich, 8793 Trofaiach (AT); Scalbert, Marie, 8700 Leoben (AT); Schlaffer, Erich, 8642 St. Lorenzen (AT); Pessl, Walter, 8700 Leoben (AT); De Los Santos, Anna Lucy, 8700 Leoben (AT)
(74) Representative: Donatello, Daniele

(56) References cited:
- US-A- 4 383 003
- US-A1- 2009 023 010
- US-A1- 2014 065 395
- US-B2- 9 219 199

## Description

### Field of the Invention

The invention relates to a component carrier such as a printed circuit board or an IC substrate, with an electrically conductive layer structure, an electrically insulating layer structure, and a glass barrier layer.

Further, the invention relates to a method of manufacturing said product, and to a use of a glass barrier.

### Technical Background

In the context of growing product functionalities of component carriers equipped with one or more electronic components and increasing miniaturization of such electronic components as well as a rising number of electronic components to be mounted on the component carriers such as printed circuit boards, increasingly more powerful array-like components or packages having several electronic components are being employed, which have a plurality of contacts or connections, with ever smaller spacing between these contacts. Removal of heat generated by such electronic components and the component carrier itself during operation becomes an increasing issue. Also an efficient protection against electromagnetic interference (EMI) becomes an increasing issue. At the same time, component carriers shall be mechanically robust and electrically and magnetically reliable so as to be operable even under harsh conditions.

In particular, providing an efficient and robust adhesion between an electrically insulating layer and an electrically conductive layer may still be seen as a major challenge.

This issue may in particular arise in the economically important step of laminating a metal (e.g. copper) layer together with a dielectric layer (e.g. a prepreg). In order to establish a sufficient adhesion, the metal surface is conventionally roughened (e.g. by micro-etching, for example to a micro roughness in the range of Ra = 0,5 µm to 1,5 µm) to provide a larger surface and hence improved adhesion.

This measure has, however, the drawback that rough metal surfaces tend to show the so-called skin-effect, leading to current losses, and thereby decreasing the quality of a signal, in particular of a high frequency signal (e.g. above 2 GHz). As a consequence, in particular in the field of high frequency signal transmission, a smooth metal surface may be preferred.

In a conventional example, to fulfill the requirement of smooth metal structures in combination with a robust adhesion to the dielectric layer, smooth copper foils with improved organic adhesion promoters and/or coating with silane/siloxane adhesion promoters can be applied. Generally, said silane/siloxane adhesion promoters for component carriers are silane or siloxane monomolecular layers that are deposited by wet chemical dipping processes.

In a further example, silanes or siloxanes are used as an adhesion layer between a metal layer and a dielectric layer, or between two dielectric layers. In this case, the silane/siloxane layer is conventionally deposited by sputtering, e.g. chemical vapor deposition (CVD). Nevertheless, this method may be considered cumbersome and economically costly.

US4383003 A discloses a metal-clad laminate comprising a substrate, a layer of copper and bonding means between said substrate and said copper layer, wherein the bonding means consist of an ultra-thin film of zinc on said copper layer with an ultra-thin film of silicon dioxide on which a silane coupling agent is coated.

US9219199 B2 discloses a method of producing an optoelectronic component comprising applying a dielectric layer to a semiconductor layer sequence, functionalize a surface of the dielectric layer, wherein both steps are simultaneously conducted by plasma-enhanced gas phase deposition, applying a metal layer to the functionalized surface, wherein the metal layer is covalently bonded to the functionalized surface.

### Summary of the Invention

There may be a need to provide an efficient and robust adhesion between an electrically insulating layer and an electrically conductive layer.

A product, a manufacture method, and a use are provided.

According to a first aspect of the invention, there is described a (electronic) component carrier such as a printed circuit board or an IC substrate), as defined by appended claim 1.

According to a second aspect of the invention, there is described a method of manufacturing a multi-layer component carrier as defined by appended claim 9.

According to a third aspect of the invention, there is described a use of a glass barrier for a multi-layer component carrier as defined by appended claim 11.

In the context of the present document, the term "glass barrier layer" may in particular refer to a layer (structure) that comprises glass material and is, at the same time, suitable to fulfill a barrier function, in particular regarding the migration of chemical species. In this context, the term "glass" may in particular refer to a non-crystalline and amorphous solid. In a preferred example, the glass comprises silicate, in particular silicon dioxide (SiO₂). In a further example, the glass comprises at least one silane and/or siloxane compound. In the invention, the glass comprises hydrophilic and hydrophobic functional groups, at the main surfaces. Since the glass barrier layer is a (continuous or discontinuous) layer, it comprises two main surfaces opposite to each other. Hereby, the two main surfaces are different

in at least one physical/chemical property, specifically regarding their surface tension (surface energy).

In the context of the present document, the term "adhesion property" may in particular refer to the tendency of (dissimilar) particles/surfaces to stick together. An adhesion property may for example be the hydrophilicity or hydrophobicity of a surface. A further adhesion property may be the surface tension or the wettability of a surface. These adhesion properties may overlap with each other. The adhesion property can be imparted through the provision of a functional group on the specific surface.

In the context of the present document, the term "surface tension" may refer to a description of the physical interaction between the surfaces, in particular the surfaces in direct contact, of two substances. The surface tension may be measured as the force per unit length (N/m) or of energy per unit area (J/m²). Even though the term "surface tension" generally refers to liquids and the term "surface energy" would refer to the equivalent property of solids, these terms may be used synonymously in the present context, specifically because the glass of the glass barrier layer may be either seen as a liquid or a solid (chemically, glass is considered as an undercooled liquid).

The surface tension (properties) may be directly linked to the wettability of a surface. For example, the difference in the surface tension of the two main surfaces may be directly seen in a different surface wettability. In an illustrative example, the first main surface may comprise rather hydrophilic properties, while the second main surface may comprise hydrophobic properties.

In the context of the present document, the term "component carrier" may particularly denote any support structure which is capable of accommodating one or more components thereon and/or therein for providing mechanical support and/or electrical connectivity. In other words, a component carrier may be configured as a mechanical and/or electronic carrier for components. In particular, a component carrier may be one of a printed circuit board, an organic interposer, a metal core substrate, an inorganic substrate and an IC (integrated circuit) substrate.

In the context of the present document, the term "IC substrate" may particularly denote a small component carrier. An IC substrate may be a, in relation to a PCB, comparably small component carrier onto which one or more components may be mounted and that may act as a connection medium between one or more chip(s) and a further PCB. More specifically, an IC substrate can be understood as a carrier for electrical connections or electrical networks as well as component carrier comparable to a printed circuit board (PCB), however with a considerably higher density of laterally and/or vertically arranged connections. Lateral connections are for example conductive paths, whereas vertical connections may be for example drill holes. These lateral and/or vertical connections are arranged within the substrate and can be used to provide electrical, thermal and/or mechanical connections of housed components or unhoused components (such as bare dies), particularly of IC chips, with a printed circuit board or intermediate printed circuit board. In an example, an IC substrate may be seen as an interposer, for example between electronic components and a printed circuit board.

In the present context, an IC substrate should not be understood as only any substrate suitable to bear an IC. Instead, the term "IC substrate" may be a technically established term for a specific, high density PCB that comprises common PCB materials.

The invention is based on the idea that an efficient and robust adhesion between an electrically conductive layer structure and an electrically insulating layer structure may be achieved, when a glass barrier layer is sandwiched between said two layer structures, and wherein the glass barrier layer comprises two main surfaces with a different adhesion property (e.g. surface tension (in particular a different wettability)).

While not wishing to be bound to a specific theory, it is believed that the migration of chemical species, such as oxygen from air or moisture, in the resin material is one of the reasons for the long and short time failures of adhesion between a metal and a dielectric. The failure of adhesion of metal to dielectric materials may thus have its origin in the migration of chemical species such as oxygen and/or moisture etc. ions, which may ultimately result in the oxidation of the metal surface, followed by catalytic reactions of formed metal oxides and other substances (eventually also with an adhesion promoter).

Conventional silane or siloxane adhesion promoters for component carriers are generally silane or siloxane monomolecular layers that are deposited by chemical wet processes, e.g. chemical dipping processes, or physical deposition processes, e.g. sputtering, which are therefore not acting as a barrier layer to block chemical substance migration towards the metal surface. Instead, these layer may themselves cause metal corrosion as well as delamination of dielectric material from the metal surface.

It has now been found by the inventors, that a glass barrier layer may be applied with a highly efficient and robust adhesion result, when the glass barrier layer comprises different physical/chemical properties (in particular regarding the adhesion) at its opposite two main surfaces, one of them being optimized for the metal layer structure, while the other one is optimized for the dielectric layer structure. In the invention, the main surface in contact with the dielectric layer structure may be rather hydrophobic, while the main surface in contact with the metal layer structure may be rather hydrophilic.

With the described approach, there may be two advantages achieved at the same time: i) a strong adhesion between the electrically conductive layer structure and the electrically insulating layer structure is enabled via the glass barrier layer, and ii) an efficient barrier layer is established to prevent migration of chemical species, thereby enabling the provision of an efficient and robust component carrier product also in the long term.

Further, high frequency signal application and/or fine line applications may be significantly improved by the described approach, in particular because smooth metal surfaces can be applied. Additionally, adhesion promoting processes, e.g. bond-film process for inner layers, may be replaced as well as micro-etching processes for outer layers.

In an embodiment, without wishing to be bound to a specific theory, the glass barrier layer may prevent copper from reacting (catalytically, in particular at elevated temperatures > 70 °C). This may prevent detaching of one copper structure with the dielectric structure, in particular breaking chemical bonds between these structures. In this way, it may be possible to reliably attach a similar or different material to a surface with a very smooth roughness of e.g. 5 nm or smaller. In an example, a pattern of fine line metal, in particular copper, traces may reliably connected /attached to electrically insulating material.

### Exemplary Embodiments

According to an embodiment, the different adhesion property comprises a different surface tension. Thereby, a different adhesion property may be realized in an efficient manner (see description above).

According to the invention, the different adhesion property comprises different functional groups at both of the two main surfaces (with respect to each other). Examples of functional groups are given further below.

According to a further embodiment, the at least one glass barrier layer is configured to suppress migration of chemical species (comprising at least one atom) between the electrically insulating layer structure and the electrically conductive layer structure. As explained above, migration of chemical species, such as ions (in particular oxygen ions), may alter the adhesion between a metal layer and a dielectric layer, e.g. by oxidizing the metal layer.

As a consequence, the suppression of migration, caused by the barrier layer, may significantly improve the adhesion between the electrically conductive layer structure and the electrically insulating layer structure.

In an example, the chemical species may comprise one of oxygen, a halide ion, and water (in particular in form of moisture).

According to a further embodiment, the at least one glass barrier layer comprises a thickness in the range 10 nm to 600 nm, in particular 50 nm to 350 nm.

This may provide the advantage that the barrier layer can be provided as an extremely thin layer that still efficiently fulfills its positive effects.

According to a further embodiment, the electrically conductive layer structure comprises at least one rough surface, in particular with a surface roughness Ra of 0.5 µm or larger, in particular 2 µm or larger, more in particular in the range 2 to 5 µm.

According to a further embodiment the at least one glass barrier layer comprises at least one rough surface, in particular at least where the electrically conductive layer structure is in contact with the glass barrier layer.

According to a further embodiment, the electrically conductive layer structure comprises at least one smooth surface, in particular with a surface roughness Ra of 200 nm or smaller, more in particular 150 nm or smaller, more in particular 100 nm or smaller, more in particular 90 nm or smaller.

This may provide the advantage that a smooth metal layer surface may be provided, while the adhesion to the dielectric layer (via the glass barrier layer) is still robust and reliable. Providing a smooth metal layer surface further provides the advantage that the skin effect (which occurs in rough surfaces) is suppressed, so that high frequency signal transportation may be improved. Additionally, the smooth metal surface may enable a fine-line structuring.

A general parameter to quantify a fine-line structuring (high density pattern) may be the line spacing (L/S), i.e. the compared lengths of metal traces and the dielectric material portions in between. The smaller the line spacing, the higher may be the density of a metal trace pattern. In an example, an L/S of 12/12 µm or lower (in particular 10/10 µm or lower, more in particular 5/5µm or lower) may be technically especially advantageous, for example with respect to miniaturization and (signal) transmission quality.

According to the invention, the at least one glass barrier layer comprises:
i) a first layer (associated with the first main surface) being in direct (physical) contact with the electrically conductive layer structure; and
ii) a second layer (associated with the second main surface) being in direct (physical) contact with the electrically insulating layer structure.

This may provide the advantage that the different properties (specifically regarding the surface tension) of the two main surfaces can be realized in a straightforward and easy-to-implement manner. In an example, both layers can be manufactured separately, each with its own properties. Then, both layers can be coupled, e.g. by lamination, or one layer can be deposited on top of the other layer, e.g. using a plasma process.

In another example, both layers can be manufactured in the same process, e.g. by providing different chemical reactions/functional groups to the respective different layers.

According to the invention, at least one glass barrier layer comprising on one main surface a first hydrophilic property and functional groups (i.e. hydroxyl functional groups) which is/are in direct contact with an electrically conductive layer structure, in particular metal (e.g. copper), and on the opposed second main surface a hydrophobic property and functional groups, which is/are different to the first hydrophilic property and functional groups, (e.g. acrylate or VTMO (vinyltrimethoxysilane)) which is/are in direct contact with at least a portion of an electrically insulating layer structure, in particular dielectric material (i.e. organic material or glass). Thereby, the first and second main surface of the glass barrier layer comprising the first hydrophilic property or hydrophobic property and functional groups may be varied in dependence of the surface properties of the electrically conductive or insulating layer structure.

This may result in a strong physical and/or chemical interaction between the surface of the electrically conductive layer structure and the first main surface of the glass barrier layer and the electrically insulating layer structure and the second main surfaces of the glass barrier layer.

According to the invention, at least one glass barrier layer comprising on one main surface a hydrophilic property and functional groups (i.e. hydroxyl functional groups) which is/are in direct contact with an electrically conductive layer structure, in particular metal (e.g. copper), and on the opposed second main surface a hydrophobic property and functional groups (e.g. HDMSO (hexamethyldisiloxane)) which is/are in direct contact with at least part of an electrically insulating layer structure, in particular dielectric material (e.g. organic material or glass).

Accordingly, where the second main surface of the glass barrier layer is in direct contact with the electrically insulating layer structure, there may be weak and/or no physical and/or chemical interaction between the electrically conductive layer structure and at least part of the electrically insulating layer structure. In a preferred example, this technical feature may be used to create cavities in a (multilayer) stack in an easy and reliable way.

According to the invention, one of the two main surfaces of the at least one glass barrier layer and the first layer comprises hydrophilic properties.

According to the invention, the other one of the two main surfaces of the at least one glass barrier layer and the second layer comprises hydrophobic properties.

This may provide the advantage that the two different main surfaces may be adjusted (and even optimized) for a direct physical contact with the electrically conductive layer structure and the electrically insulating layer structure, respectively. A metal layer and a dielectric layer are generally quite different in their physical/chemical properties, so that different surface tensions, enabling different hydrophilic/hydrophobic properties (and a different wettability), may be well suited to adjust an advantageous degree of adhesion.

According to the invention, one of the two main surfaces of the at least one glass barrier layer and the first layer comprises at least one functional group (at the silane/siloxane component) for providing the hydrophilic properties. Thereby, the hydrophilic properties may be provided in an efficient and selective manner.

Such hydrophilic properties may be achieved for example by one of the following functional groups: imine, amine, thiol, thioamide, phosphate, hydroxyl, thiazole, imidazole, acrylate, methacrylate, an alcohol group, in particular 3-hydroxypropyl or 2-hydroxyethyl. In an example, acrylate and methacrylate may be preferred silanes for the glass barrier layer. Alcohol groups to be included may in particular comprise 3-hydroxypropyl or 2-hydroxyethyl.

In an example, the first layer comprises a silane/siloxane containing nitrogen groups and/or silane/siloxanes in a mixture with molecules containing a nitrogen group such as 3-ureidopropyltriethoxysilane or siloxane, 3-aminopropyl)tiethoxysilan, trimethoxylsilylbenzotriazole, triallylisocyanurate, divinylbenzimidazole, diallylamine, vinylimidazole, or cyclic azasilane or siloxanes.

According to a the invention, the other one of the two main surfaces of the at least one glass barrier layer and the second layer comprises at least one functional group (at the silane/siloxane component) for providing the hydrophobic properties.

Such hydrophobic properties may be achieved for example by one of the following functional groups: epoxy, allyl, amine, vinyl, alkyl, anhydride, in particular maleic anhydride, furane, pyrrole, thiophene, and/or a cyclic unsaturated alkene, in particular cyclic pentene. In an example, preferred groups may include alkyl, allyl, vinyl, and a cycle unsaturated alkene.

In a further example, there is used a hydrophobic silane/siloxane especially containing double bonds which will be oxidized in a plasma process, yielding hydrophilic properties. For instance, a hydrophobic allyl-silane double bond can be oxidized in said plasma process into 3-hydroxypropyl, which is hydrophilic.

In a further example, APTES (3-aminopropyl)triethoxysilane, containing no double bonds, will be either oxidized into SiOₓ or polymerized into plasma without oxidation (as there is no double bond) and therefore stay hydrophobic after the plasma process.

According to a further embodiment, the second layer is deposited on the first layer by a (cold) (atmospheric pressure) plasma (spray) process. This may provide an excellent adhesion of the second layer on the first layer.

According to a further embodiment, the second layer comprises functional silanes/siloxanes that form a stable bond with the dielectric material and are hydrophobic depending on the dielectric material (the surface tension of the second layer may be selected according to the surface tension of the dielectric material). The second layer may comprise silane/siloxane functional (organic) groups that react with the dielectric material, such as alcohol, amine, thiol-, epoxy- or double bonds as allyl- groups and a mixture of these groups. Further, functional silanes/siloxanes can be used, such as epoxysilane, epoxysiloxane, aminosilane, aminosiloxane, allylsilane, allylsiloxane, hexamethyldisiloxane.

According to a further embodiment, the at least one glass barrier layer comprises silicon dioxide, SiO₂. This may provide the advantage that an established and cost-efficient industry material can be directly applied and eventually functionalized as desired.

In an example, the silane/siloxane is only partially oxidized into SiOx, e.g. during a plasma process. The polymerized silanes/siloxanes may form SiOx-R, with R giving the functionality of the layer (either a hydrophilic group like amine and alcohol or a hydrophobic group like methyl).

According to a further embodiment, the at least one glass barrier layer comprises particles that are (at least partially) embedded in the at least one glass barrier layer. In this manner, specific (surface) properties may be provided. In particular, the particles may improve the integrity, which may be crucial for high frequency applications. Furthermore, the particles may be chosen as plasma etchable to enable patterning and via plating during further production steps.

According to a further embodiment, the particles comprise at least two different shapes. Thereby, the particles may be adapted to specific applications in a flexible manner. The shapes are hereby not limited and may be for example rectangular, circular, or polygonal. Further, the shapes may include a star, a triangle, a sphere, a shape with spikes, etc.

According to a further embodiment, the partially embedded particles affect the surface roughness of the at least one glass barrier layer. Thereby, the (normally smooth) glass barrier layer surface may be adapted to a specific roughness, if desired. For example, a roughness Ra of 300 nm or smaller may thereby be implemented.

According to a further embodiment, the embedded particles comprise a metal oxide, for example SiO₂, TiO₂, Al₂O₃, fused silica, or zeolithe.

According to a further embodiment, the embedded particles are nonporous particles. According to a further embodiment, the particles can be dry-etched by fluorine plasma gases. Optionally, the particles can be coated to improve the dispersion and the adhesion with the surrounding glass barrier layer.

According to a further embodiment, the embedded particles impart hydrophilic or hydrophobic properties. Depending on the material/surface of the particles, they may provide either hydrophobic or hydrophilic properties, in particular in addition to the glass barrier main surface properties.

According to a further embodiment, the embedded particle diameters are in the micrometer range (1 µm to 1000 µm) and/or nanometer range (1 nm to 1000 nm). This enables a certain design flexibility. Preferably, the particle diameters may be in a range of a surface roughness, for example lower than 500 nm, in particular 300 nm or lower. Further, the particle diameter may be larger than 100 nm, in particular larger than 200 nm.

According to a further embodiment, there can be 10% or more, in particular 15% or more, particles with respect to the glass barrier layer material (volume or mass).

According to a further embodiment, there can be 30% or less, in particular 15% or less, particles with respect to the glass barrier layer material (volume or mass) (otherwise, it may be an amorphous layer in an example).

According to a further embodiment, the embedded particles are at least partially embedded in the first surface/portion and/or the first layer and/or in the second surface/portion and/or the second layer. This may provide the advantage that the robust adhesion between the respective layer structure and the glass barrier layer is further improved.

According to a further embodiment, the electrically insulating layer structure comprises an organic material, in particular a resin, more in particular a reinforced resin, e.g. a fiber-reinforced resin (prepreg) or a sphere-reinforced resin. Thereby, economically important materials from the component carrier industry can be directly applied.

According to a further embodiment, the electrically insulating layer structure comprises an inorganic material, in particular a glass (being different from the glass barrier layer) or a ceramic. Also these materials may be relevant in specific applications.

According to a further embodiment, the electrically conductive layer structure comprises a metal foil, in particular a copper foil. Thereby, economically important materials from the component carrier industry can be directly applied.

According to a further embodiment, the product comprises an adhesion between the electrically conductive layer structure (and/or the electrically insulating layer structure) and (via) the at least one glass barrier layer of 40 N/m or more, in particular 100 N/m or more, in particular 400 N/m or more, more in particular 500 N/m or more. Accordingly, a very efficient and robust adhesion can be provided.

In an example, it may be seen a challenge to obtain reliable adhesion on a smooth (e.g. 100 nm roughness) metal layer. Nevertheless, the adhesion of glass barrier layer (SiOx/SiOR layer) on the (smooth) metal layer can be stronger than the bonding of the dielectric layer to the glass barrier layer.

In a specific example, the adhesion withstands a solder dip test two times during 60 seconds (usually it would be only 10 s). The adhesion after six times reflow without moisture may still be > 500 N/m.

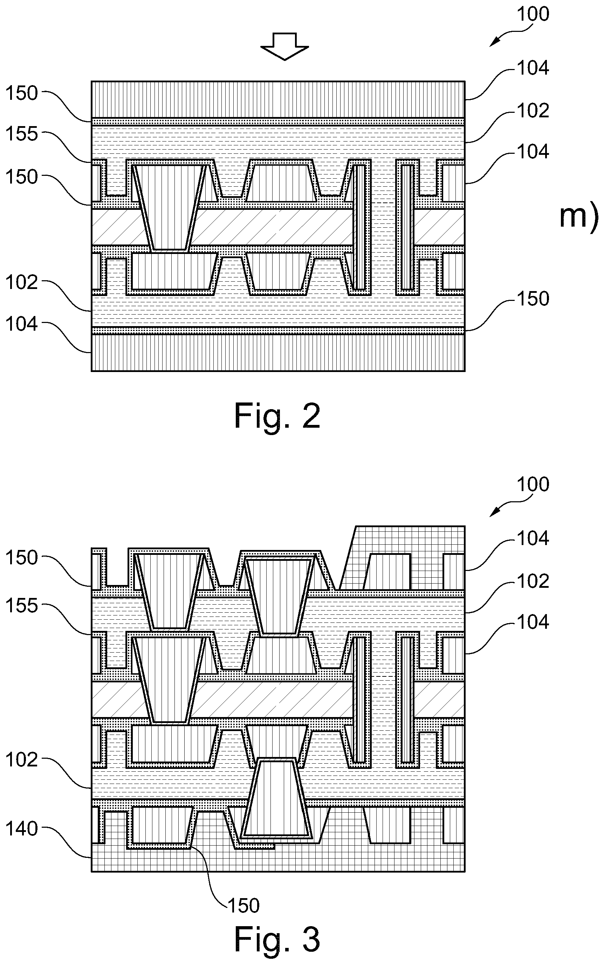

According to a further embodiment the plurality of electrically conductive layer structures of the multi-layer component carrier of the invention are at least partially coated by respective glass barrier layers (see e.g. Figure 3). Thereby, the highly efficient binding between electrically conductive layer structures and electrically insulating layer structures may be ensured throughout the whole multi-layer stack of a component carrier product, resulting in a highly stable and reliable product.

According to a further embodiment, the glass barrier layer may be in direct contact with two or more (three or more, four or more) surface(-portion)s of the electrically conductive layer structure and/or the electrically insulating layer structure.

According to the invention, the multi-layer component carrier comprises at least two glass barrier layers (in particular three or more, four or more, etc.). Preferably, the at least two glass barrier layers are (at least partially) in contact to each other (for example one formed (at least partially) above the other).

According to a further embodiment, the portions that are in contact of the at least two glass barrier layers comprise the same surface tension, preferable hydrophobic surfaces or hydrophilic surfaces. Thereby, the efficient adhesion properties may be provided throughout the whole component carrier layer stack.

According to a further embodiment, the glass barrier layer has been manufactured with a plasma (spray) process, in particular an atmospheric pressure plasma process, more in particular with a cold atmospheric pressure plasma process. Said manufacture process may be reflected in the product by the presence of not fully oxidized functional groups (whereby fully oxidized functional groups would be expected in case of a hot (atmospheric pressure) plasma process) and/or a higher carbon content in comparison to a hot (atmospheric pressure) plasma process. Said differences may be detectable with established methods such as STM, AFM, FTIR, SEM, IRRAS, XPS, etc.

This may provide the advantage that the described glass barrier layer and the corresponding advantages can be formed using a reliable and cost-efficient manufacture process. In comparison to established plasma spray processes, a cold (atmospheric pressure) plasma process may be more economic. In particular, costs of heating, vacuum, or argon gas may be saved.

According to a further embodiment, forming the glass barrier layer comprises providing a glass barrier layer preform that comprises at least one silane and/or siloxane compound, and/or performing a (atmospheric pressure) plasma process, thereby partially oxidizing the glass barrier layer preform to form silicon dioxide from at least part of the silane and/or siloxane compounds, to form the glass barrier layer. Accordingly, an oxidation may be performed directly in the (cold atmospheric pressure) plasma process, thereby omitting an additional post-oxidation process.

In an example, the (liquid) silane/siloxane oxidation may occur during (cold) plasma process, when precursors are evaporated and mixed with the plasma gas, acting as a carrier. Before the plasma process, pre-activation can be conducted to activate the surface by increasing the surface energy and burning away the dust on the substrate. This step may be particularly important for a very smooth surface and/or surface with low wetting properties.

According to a specific embodiment, the glass barrier layer is applied by an atmospheric pressure plasma spray coating process using air or nitrogen containing 1-10 % oxygen as a carrier gas. Silane/siloxane components and optionally nano- or microparticles may be fed to the atmospheric pressure plasma spray coating process by a suitable method such as a nebulizer into the air or a nitrogen carrier gas flow. Plasma activation may then be done by atmospheric pressure plasma during the deposition process, in particular on a metallic surface.

According to a further embodiment, the method further comprises: providing the glass barrier layer, in particular on the electrically conductive layer structure, by a cold (atmospheric pressure) plasma process, in particular at a temperature of 200° or lower, in particular 150° or lower. The cold plasma process saves energy costs and may function surprisingly efficient in comparison to a hot plasma process. Further, a vacuum is avoided, that requires further economic efforts.

Alternatively, a hot atmospheric pressure plasma process (in particular at a temperature of more than 200°) can be applied.

According to a further embodiment, the method further comprising: cleaning the surface of the electrically conductive layer structure or the electrically insulating layer structure by the (cold atmospheric pressure) plasma process before providing the glass barrier layer. This measure may further improve the adhesion properties. In an embodiment, (oxidation and) cleaning may be performed within the plasma process.

According to a further embodiment, the method is (essentially) free of a sputtering process, in particular physical vapor deposition (PVD) or chemical vapor deposition (CVD) process. In particular, the method is (essentially) free of a hot (atmospheric pressure) plasma process. As discussed above, a (cold atmospheric pressure) plasma process may be more economic and less cumbersome, yet providing comparable results.

According to a further embodiment, the method comprising: roughening a surface of the electrically conductive layer structure and then forming the glass barrier layer on the rough surface.

According to a further embodiment, the method comprising roughening a surface of the glass barrier layer and then forming the electrically conductive layer structure on the rough surface.

According to a further embodiment, a UV-sensitive functional silanes/siloxanes, such as thiol- and allyl- siloxanes or silanes, is added to the feed stream to allow a functionalization of the layer by UV light. After patterning of the UV-sensitive glass barrier layer, selective (electroless) metal deposition can be applied.

According to a further embodiment, one plasma post-treatment step (such as plasma oxidation step or amine functionalization) is applied after each deposited glass barrier layer to thereby improve the adhesion.

According to a further embodiment, the described process of forming the glass barrier layer may be applied in combination with other component carrier manufacturing processes, e.g. subtractive processes, in particular etching, or additive processes, e.g. (m)SAP and/or NIL (nanoimprint lithography) (before or after the steps listed above).

According to a further embodiment, the method is (essentially) additive and (essentially) free of (micro-) etching. As the surface thickness is in the nanometer range, the roughness of the electrically conductive layer structure is remaining the same. Only if embedded particles are added inside the glass barrier layer, the overall roughness (for example copper surface around 100 nm roughness plus glass barrier layer with around 300 nm rough from particles) is changed. The electrically conductive layer structure surface roughness in itself may remain the same.

According to a further embodiment, for fine-line and high frequency applications, a smooth metal (copper) surface is important. Otherwise, there may be occurring a skin effect, diminishing the electrical properties. For example, for a 2 µm line/space, micro-etching of 0,5 µm may be not applicable, because otherwise one fourth of the lines could be etched away.

According to an embodiment, the adhesion between a smooth metal layer (copper foil) (e.g. surface roughness < 100 nm) and a dielectric layer (e.g. prepreg) is improved. The fine lines may be structured by wet etching of the metal layer. Additionally or alternatively, the adhesion between a very smooth dielectric layer (such as glass, PID, ABF, etc. (e.g. surface roughness < 100 nm) and fine lines formed by metal plating may be improved.

According to an embodiment, fine lines are applied, e.g. < 15 µm line space, especially < 5 µm line/space. Usually, when it comes to fine lines, the adhesion may be very critical, so only an expensive sputtering process can give sufficient adhesion to fine lines formed by plating. Other existing processes for sufficient adhesion between metal and dielectric require a wet etching of the metal structure or dielectric substrate, thereby generating a roughness of minimum 150 nm.

According to an embodiment, another function of the glass barrier layer is to avoid copper migration, which may be critical for fine-line spacing.

According to an embodiment, at least a portion of the electrically conductive layer structure is in contact with both of the two main surfaces of the glass barrier layer. This can be the case, for example, when the electrically conductive layer structure is oriented vertically or tilted in the stack. In a further embodiment, the electrically conductive layer structure may thereby contact the two main surfaces of two or more glass barrier layers.

According to an embodiment, the glass barrier layer comprises self-aligning properties. This may have the advantage of better adhesion between at least two layers of the product.

In this document, the term "self-aligning property" may define alignment of the glass barrier layer so, that the hydrophilic surface of the glass barrier layer may be oriented towards another hydrophilic surface, in particular in direct contact with another hydrophilic surface, and/or that the hydrophobic surface of the glass barrier layer may be oriented toward another hydrophobic surface, in particular in direct contact with another hydrophobic surface. Hydrophilic surfaces may comprise electrically conductive layer structures and/or hydrophilic portions of the glass barrier layer. Hydrophobic surfaces may comprise electrically insulating layer structures and/or hydrophobic portions of the glass barrier layer.

According to a further embodiment, the product further comprises: at least one (at least partially (metal-) filled) via, and a titanium-containing seed layer (for example a Ti/Cu seed layer), wherein the titanium-containing seed layer is located only at the sidewall and/or the bottom of the at least one via. In other words, the product may be, in an example, (essentially) free of the titanium-containing seed layer (in particular regarding the glass barrier layer) except at sidewall/bottom of at least one via, in particular a fine pattern via.

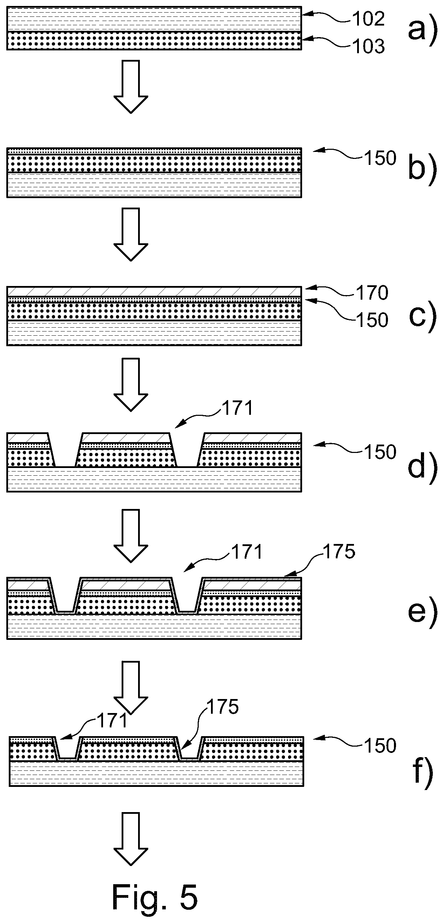

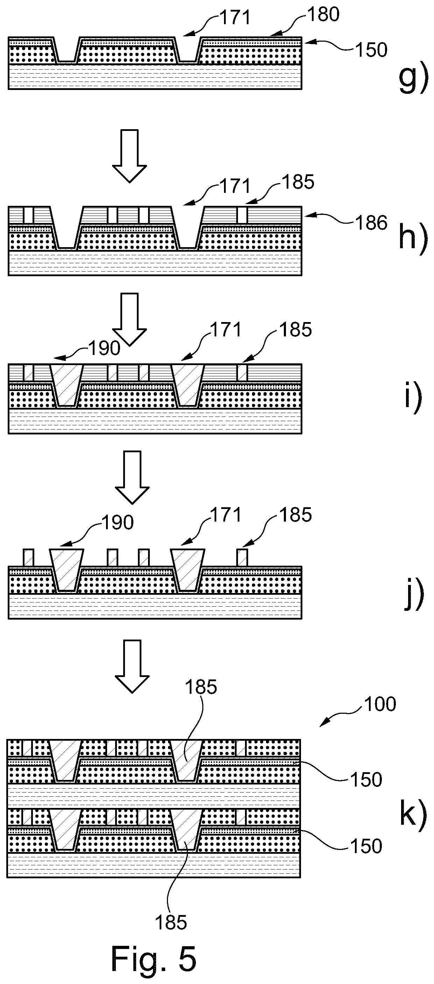

According to a further embodiment, the glass barrier layer improves the adhesion between a very smooth (Ra < 100 nm roughness) electrically insulating layer structure (dielectric) such as glass, PID, ABF, and fine line electrically conductive traces/pattern (e.g. formed by copper plating). In an example, a seed layer for an additive process can be E-less or sputtering. In case of Ti/Cu sputtering, the Ti layer could be (at least partially) replaced by the glass barrier layer. Thereby, costs and efforts may be saved, while the (electrical) performance is increased (see also Figure 5).

Usually, to form fine lines (e.g. < 5 µm) and small vias, a sputtered Ti/Cu seed layer can be used. Titanium can hereby act as a barrier and as an adhesion promoter while ensuring the electrical connection. However, the titanium-containing (seed) layer may be expensive, require special chemistry to be etched, and is less conductive than copper (e.g. twenty times less).

These drawbacks may be overcome using the described glass barrier layer. For example, a silane adhesion and barrier layer, coated with cold plasma (glass barrier layer), is replacing the Ti layer, providing the advantage that no Ti etching is required and that there may be no loss of the electrical conductivity.

According to a further embodiment, the method is (essentially) free of a titanium-etching step.

Generally, an additive production step (e.g. (m)SAP, NIL process) can be applied to an electrically conductive layer. Then a protection mask can be applied and developed to create portions, where electrically conductive layer (metal) is exposed. Then a plating step can be performed. Afterwards, the protection layer and the base material of the electrically conductive layer (metal) may be removed in order to not electrically connect/conduct the entire layer. When sputtering is applied to create an electrically conductive seed layer to start the process of an additive process step, a thin titanium layer can be created on top of an insulating layer structure. On top of the titanium layer, a copper layer may be then provided.

Since titanium can be removed together with the protection layer according to an embodiment (see e.g. Figure 5e), only titanium is then available in the vias. In other words, the titanium etching step may be skipped (and cost/efforts may be saved), since titanium is only part of the electrically conductive via.

In an embodiment, the component carrier is configured as one of a printed circuit board, a substrate (in particular an IC substrate), and an interposer.

In an embodiment, the component carrier is shaped as a plate. This contributes to the compact design, wherein the component carrier nevertheless provides a large basis for mounting components thereon. Furthermore, in particular a naked die as example for an embedded electronic component, can be conveniently embedded, thanks to its small thickness, into a thin plate such as a printed circuit board.

In an embodiment, the component carrier stack comprises at least one electrically insulating layer structure and at least one electrically conductive layer structure. For example, the component carrier may be a laminate of the mentioned electrically insulating layer structure(s) and electrically conductive layer structure(s), in particular formed by applying mechanical pressure and/or thermal energy. The mentioned stack may provide a plate-shaped component carrier capable of providing a large mounting surface for further components and being nevertheless very thin and compact.

In the context of the present application, the term "stack" may particularly denote a sequence of two or more layer structures formed on top of each other. For instance, layer structures of a layer stack may be connected by lamination, i.e. the application of heat and/or pressure. Preferably, the stacked layer structures may be arranged parallel to each other.

In the context of the present application, the term "layer structure" may particularly denote a continuous layer, a patterned layer, or a plurality of nonconsecutive islands within a common plane.

In the context of the present application, the term "printed circuit board" (PCB) may particularly denote a plate-shaped component carrier which is formed by laminating several electrically conductive layer structures with several electrically insulating layer structures, for instance by applying pressure and/or by the supply of thermal energy. As preferred materials for PCB technology, the electrically conductive layer structures are made of copper, whereas the electrically insulating layer structures may comprise resin and/or glass fibers, so-called prepreg or FR4 material. The various electrically conductive layer structures may be connected to one another in a desired way by forming holes through the laminate, for instance by laser drilling or mechanical drilling, and by partially or fully filling them with electrically conductive material (in particular copper), thereby forming vias or any other through-hole connections. The filled hole either connects the whole stack, (through-hole connections extending through several layers or the entire stack), or the filled hole connects at least two electrically conductive layers, called via. Similarly, optical interconnections can be formed through individual layers of the stack in order to receive an electro-optical circuit board (EOCB). Apart from one or more components which may be embedded in a printed circuit board, a printed circuit board is usually configured for accommodating one or more components on one or both opposing surfaces of the plate-shaped printed circuit board. They may be connected to the respective main surface by soldering. A dielectric part of a PCB may be composed of resin with reinforcing fibers (such as glass fibers).

In the context of the present application, the term "substrate" may particularly denote a small component carrier. A substrate may be a, in relation to a PCB, comparably small component carrier onto which one or more components may be mounted and that may act as a connection medium between one or more chip(s) and a further PCB. For instance, a substrate may have substantially the same size as a component (in particular an electronic component) to be mounted thereon (for instance in case of a Chip Scale Package (CSP)). In another embodiment, the substrate may be substantially larger than the assigned component (for instance in a flip chip ball grid array, FCBGA, configuration). More specifically, a substrate can be understood as a carrier for electrical connections or electrical networks as well as component carrier comparable to a printed circuit board (PCB), however with a considerably higher density of laterally and/or vertically arranged connections. Lateral connections are for example conductive paths, whereas vertical connections may be for example drill holes. These lateral and/or vertical connections are arranged within the substrate and can be used to provide electrical, thermal and/or mechanical connections of housed components or unhoused components (such as bare dies), particularly of IC chips, with a printed circuit board or intermediate printed circuit board. Thus, the term "substrate" also includes "IC substrates". A dielectric part of a substrate may be composed of resin with reinforcing particles (such as reinforcing spheres, in particular glass spheres).

The substrate or interposer may comprise or consist of at least a layer of glass, silicon (Si) and/or a photoimageable or dry-etchable organic material like epoxy-based build-up material (such as epoxy-based build-up film) or polymer compounds (which may or may not include photo- and/or thermosensitive molecules) like polyimide or polybenzoxazole.

In an embodiment, the at least one electrically insulating layer structure (dielectric layer) comprises at least one of the group consisting of a resin or a polymer, such as epoxy resin, cyanate ester resin, benzocyclobutene resin, bismaleimide-triazine resin, polyphenylene derivate (e.g. based on polyphenylenether, PPE), polyimide (PI), polyamide (PA), liquid crystal polymer (LCP), polytetrafluoroethylene (PTFE) and/or a combination thereof. Reinforcing structures such as webs, fibers, spheres or other kinds of filler particles, for example made of glass (multilayer glass) in order to form a composite, could be used as well. A semi-cured resin in combination with a reinforcing agent, e.g. fibers impregnated with the above-mentioned resins is called prepreg. These prepregs are often named after their properties e.g. FR4 or FR5, which describe their flame retardant properties. Although prepreg particularly FR4 are usually preferred for rigid PCBs, other materials, in particular epoxy-based build-up materials (such as build-up films) or photoimageable dielectric materials, may be used as well. For high frequency applications, high-frequency materials such as polytetrafluoroethylene, liquid crystal polymer and/or cyanate ester resins, may be preferred. Besides these polymers, low temperature cofired ceramics (LTCC) or other low, very low or ultra-low DK materials may be applied in the component carrier as electrically insulating structures.

In an embodiment, the at least one electrically conductive layer structure (for example electric interconnection, terminal, pad, via, etc.) comprises at least one of the group consisting of copper, aluminum, nickel, silver, gold, palladium, tungsten, magnesium, carbon, (in particular doped) silicon, titanium, and platinum. Although copper is usually preferred, other materials or coated versions thereof are possible as well, in particular coated with supra-conductive material or conductive polymers, such as graphene or poly(3,4-ethylenedioxythiophene) (PEDOT), respectively.

At least one further component may be embedded in and/or surface mounted on the stack.

The component and/or the at least one further component can be selected from a group consisting of an electrically non-conductive inlay, an electrically conductive inlay (such as a metal inlay, preferably comprising copper or aluminum), a heat transfer unit (for example a heat pipe), a light guiding element (for example an optical waveguide or a light conductor connection), an electronic component, or combinations thereof. An inlay can be for instance a metal block, with or without an insulating material coating (IMS-inlay), which could be either embedded or surface mounted for the purpose of facilitating heat dissipation. Suitable materials are defined according to their thermal conductivity, which should be at least 2 W/mK (milliKelvin). Such materials are often based, but not limited to metals, metal-oxides and/or ceramics as for instance copper, aluminium oxide (Al2O3) or aluminum nitride (AIN). In order to increase the heat exchange capacity, other geometries with increased surface area are frequently used as well. Furthermore, a component can be an active electronic component (having at least one p-n-junction implemented), a passive electronic component such as a resistor, an inductance, or capacitor, an electronic chip, a storage device (for instance a DRAM or another data memory), a filter, an integrated circuit (such as field-programmable gate array (FPGA), programmable array logic (PAL), generic array logic (GAL) and complex programmable logic devices (CPLDs)), a signal processing component, a power management component (such as a field-effect transistor (FET), metal-oxide-semiconductor field-effect transistor (MOSFET), complementary metal-oxide-semiconductor (CMOS), junction field-effect transistor (JFET), or insulated-gate field-effect transistor (IGFET), all based on semiconductor materials such as silicon carbide (SiC), gallium arsenide (GaAs), gallium nitride (GaN), gallium oxide (Ga2O3), indium gallium arsenide (InGaAs), indium phosphide (InP) and/or any other suitable inorganic compound), an optoelectronic interface element, a light emitting diode, a photocoupler, a voltage converter (for example a DC/DC converter or an AC/DC converter), a cryptographic component, a transmitter and/or receiver, an electromechanical transducer, a sensor, an actuator, a microelectromechanical system (MEMS), a microprocessor, a capacitor, a resistor, an inductance, a battery, a switch, a camera, an antenna, a logic chip, and an energy harvesting unit. However, other components may be embedded in the component carrier. For example, a magnetic element can be used as a component. Such a magnetic element may be a permanent magnetic element (such as a ferromagnetic element, an antiferromagnetic element, a multiferroic element or a ferrimagnetic element, for instance a ferrite core) or may be a paramagnetic element. However, the component may also be a IC substrate, an interposer or a further component carrier, for example in a board-in-board configuration. The component may be surface mounted on the component carrier and/or may be embedded in an interior thereof. Moreover, also other components, in particular those which generate and emit electromagnetic radiation and/or are sensitive with regard to electromagnetic radiation propagating from an environment, may be used as component(s).

In an embodiment, the component carrier is a laminate-type component carrier. In such an embodiment, the component carrier is a compound of multiple layer structures which are stacked and connected together by applying a pressing force and/or heat.

After processing interior layer structures of the component carrier, it is possible to cover (in particular by lamination) one or both opposing main surfaces of the processed layer structures symmetrically or asymmetrically with one or more further electrically insulating layer structures and/or electrically conductive layer structures. In other words, a build-up may be continued until a desired number of layers is obtained.

After having completed formation of a stack of electrically insulating layer structures and electrically conductive layer structures, it is possible to proceed with a surface treatment of the obtained layers structures or component carrier.

In particular, an electrically insulating solder resist may be applied to one or both opposing main surfaces of the layer stack or component carrier in terms of surface treatment. For instance, it is possible to form such a solder resist on an entire main surface and to subsequently pattern the layer of solder resist so as to expose one or more electrically conductive surface portions which shall be used for electrically coupling the component carrier to an electronic periphery. The surface portions of the component carrier remaining covered with solder resist may be efficiently protected against oxidation or corrosion, in particular surface portions containing copper.

It is also possible to apply a surface finish selectively to exposed electrically conductive surface portions of the component carrier in terms of surface treatment. Such a surface finish may be an electrically conductive cover material on exposed electrically conductive layer structures (such as pads, conductive tracks, etc., in particular comprising or consisting of copper) on a surface of a component carrier. If such exposed electrically conductive layer structures are left unprotected, then the exposed electrically conductive component carrier material (in particular copper) might oxidize, making the component carrier less reliable. A surface finish may then be formed for instance as an interface between a surface mounted component and the component carrier. The surface finish has the function to protect the exposed electrically conductive layer structures (in particular copper circuitry) and enable a joining process with one or more components, for instance by soldering. Examples for appropriate materials for a surface finish are Organic Solderability Preservative (OSP), Electroless Nickel Immersion Gold (ENIG), Electroless Nickel Immersion Palladium Immersion Gold (ENIPIG), Electroless Nickel Electroless Palladium Immersion Gold (ENEPIG), gold (in particular hard gold), chemical tin (chemical and electroplated), nickel-gold, nickel-palladium, etc. Also nickel-free materials for a surface finish may be used, in particular for high-speed applications. Examples are ISIG (Immersion Silver Immersion Gold), and EPAG (Electroless Palladium Autocatalytic Gold).

### Brief Description of the Drawings

The aspects defined above and further aspects of the invention are apparent from the examples of embodiment to be described hereinafter and are explained with reference to these examples of embodiment.
Figures 1 illustrates a product according to an illustrative example not part of the present invention.
Figure 2 illustrates a method of manufacturing the product that can be used in the present invention.
Figures 3 and 4 respectively illustrate a multi-layer component carrier according to exemplary embodiments of the present invention.
Figure 5 illustrates a method of manufacturing a product with fine line vias that can be used in the present invention.

### Detailed Description of the Drawings

The illustrations in the drawings are schematic. In different drawings, similar or identical elements are provided with the same reference signs.

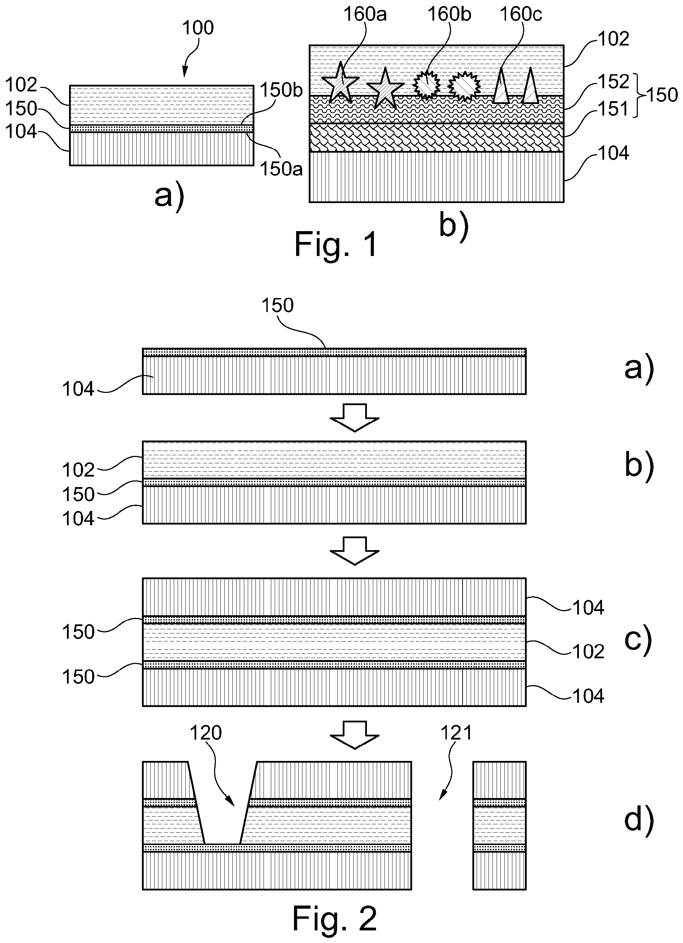

**Figure 1a** illustrates a (component carrier) product 100 according to an illustrative example not part of the present invention. In this basic example, the product 100 comprises three layers:
i) an electrically insulating layer structure 102, e.g. a prepreg,
ii) an electrically conductive layer structure 104, e.g. a copper foil, and
iii) at least one glass barrier layer 150 sandwiched between the electrically insulating layer structure 102 and the electrically conductive layer structure 104.

The at least one glass barrier layer 150 comprises two main surfaces 150a, 150b, wherein the first main surface 150a is in direct contact with the electrically conductive layer structure 104 and the second main surface 150b is in direct contact with the electrically insulating layer structure 102. The first main surface 150a is located on opposed side to the second main surface 150b. In order to establish most efficient and robust adhesion, the two main surfaces 150a, 150b comprise a different adhesion property (here a different surface tension), being optimized to the respective layer structure 102, 104 in direct contact.

The glass barrier layer is thereby additionally configured to suppress migration of chemical species (e.g. oxygen or vapor) between the electrically insulating layer structure 102 and the electrically conductive layer structure 104.

The at least one glass barrier layer 150 is configured extremely thin here with a thickness (in stack thickness direction) in the lower range nanometer range (50 nm to 350 nm). Due to the strong adhesion between glass barrier layer 150 and the electrically conductive layer structure 104, the latter can be realized as smooth surface (with a surface roughness Ra of 100 nm or smaller) copper foil. The glass barrier layer 150 comprises silicon dioxide and at least one silane and/or siloxane compound.

**Figure 1b** illustrates a more detailed embodiment of the (component carrier) product 100 according to an illustrative example not part of the present invention, wherein the glass barrier layer 150 comprises a first layer 151, which includes the first main surface 150a, and a second layer 152, which includes the second main surface 150b. While the first layer 151 comprises hydrophilic properties (e.g. realized by hydrophilic functional groups), in particular at first main surface (region) 150a, the second layer 152 comprises hydrophobic properties (e.g. realized by hydrophobic functional groups), in particular at second main surface (region) 150b. The first main surface 150a and the second main surface 150b are located on opposed sides. In other words, the first main surface 150a and the second main surface 150b are not in direct physical contact with each other.

Furthermore, particles 160 (e.g. metal oxides) are partially embedded in the at least one glass barrier layer 150, in particular in this example in the second layer 152. Said particles 160 comprise different shapes, in this example: star shape 160a, spherical shape 160b, and triangular shape 160c. The partially embedded particles 160 affect the surface roughness of the glass barrier layer 150 and are further partially embedded in the electrically insulating layer structure 102.

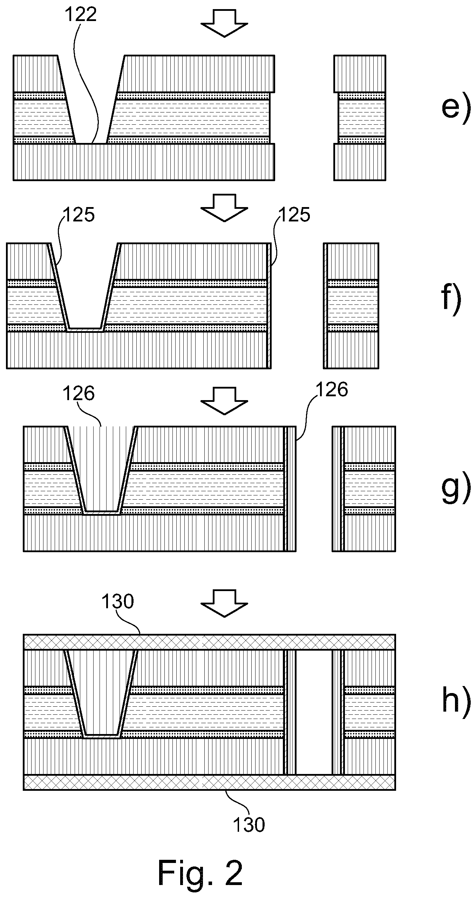

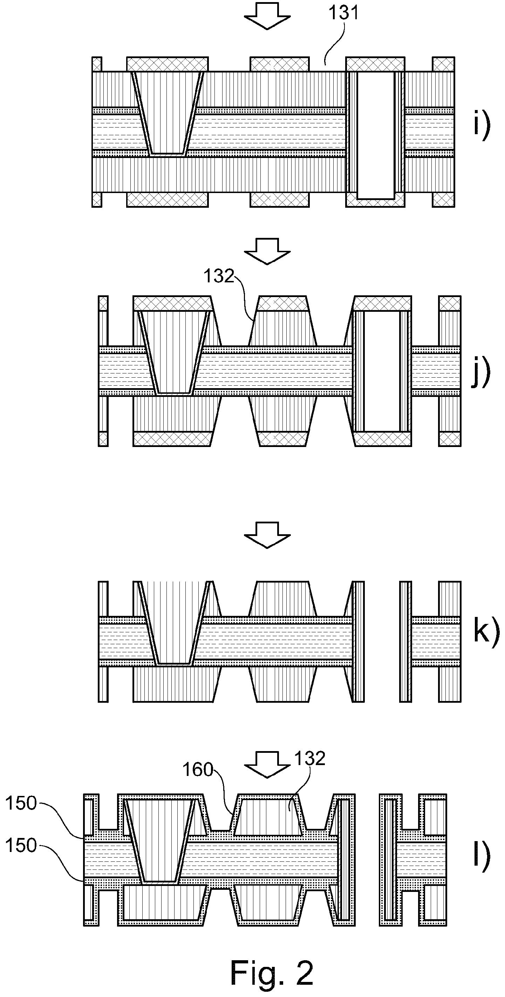

**Figure 2** illustrates a method of manufacturing the product 100 according to an illustrative example not part of the present invention.

Figure 2a: an electrically conductive layer structure 104, e.g. a copper foil, is coated, preferably by a cold atmospheric pressure plasma process, to form a glass barrier layer 150 with different surface tension at the main surfaces.

Figure 2b: an electrically insulating layer structure 102, e.g. a prepreg, is deposited on top of the glass barrier layer 150.

Figure 2c: a further electrically conductive layer structure 104 and a further glass barrier layer 150 are formed in said order on top of the electrically insulating layer structure 102.

Figure 2d: a blind hole 120 and a through hole 121 are formed, e.g. by laser drilling or mechanical drilling, in the layer stack.

Figure 2e: after the drilling process, a dry or wet etching process (e.g. containing fluoride gases) is (optionally) performed to remove the glass barrier layer 150 at the bottom 122 of the blind hole 120. As an alternative, a UV-laser cleaning process can be applied.

Figure 2f: a (copper) seed layer 125 is applied to cover the sidewalls of the holes 120, 121 and the bottom 122 of the blind hole 120, e.g. by a sputtering process.

Figure 2g: the blind hole 120 is completely filled by electrically conductive material (copper), in particular by plating, while only the sidewalls of the through hole 121 are covered by said material (in particular thereby forming a plated through hole).

Figure 2h: for structuring of the electrically conductive layer structures 104 via a photolithography process, a UV-sensitive photo film 130 is deposited at the exposed surface, in particular on the electrically conductive layer structures 104. Thereby, the through hole 121 is temporarily closed.

Figure 2i and j: after structuring and developing of the photo film 130, the openings form a pattern 131 in the photo film 130, which allows an etching process of the electrically conductive layer structures 104, resulting in copper (frustoconical shaped) traces 132. It can be seen that the glass barrier layer 150 is not etched during said structuring process.

Figure 2k: after structuring of the electrically conductive layer structures 104, the photo film 130 is stripped.

Figure 2l: on top of the electrically conductive traces 132, as well as on the glass barrier layer 150, a further glass barrier layer 155 is deposited, preferably by a cold atmospheric pressure plasma process. In this example, all exposed surfaces are covered by said further glass barrier layer 155. The further glass barrier layer 155 extends over a broader stack thickness portion (two adjacent, or more layers and distance between the two adjacent layers), thereby covering surfaces parallel to the main elongation direction of the layer stack (along x-direction) and sidewalls of the (tapered shaped) traces 132. This is in contrast to the glass barrier layer 150, which is extending within a plane.

Figure 2m: the further glass barrier layer 155 is covered by a further electrically insulating layer structure 102. Then, another glass barrier layer 150 is deposited and, on top, another electrically conductive layer structure 104 is formed.

**Figure 3** illustrates a multi-layer component carrier 100 according to an exemplary embodiment of the present invention. Said component carrier 100 is obtained based on the component carrier 100 of Figure 2m. The glass barrier layer 150 is shown here as a surface finish for outer electrically conductive layer structures 104, e.g. for HF antenna structures. Therefore, the glass barrier layer 150 can be applied in areas where soldering of components is not required, e.g. as a copper corrosion protection.

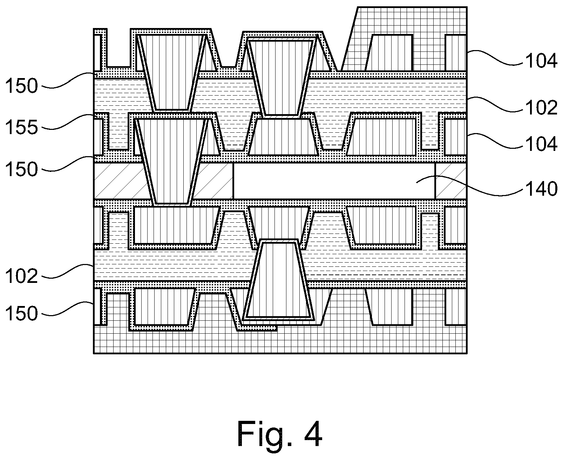

**Figure 4** a multi-layer component carrier 100 according to an exemplary embodiment of the present invention. The product 100 of Figure 4 is very similar to the one shown in Figure 3, the difference being that a cavity 140 is formed in the central electrically insulating layer structure 102 (this can be a core structure, e.g. cured FR4). In this example, an electronic component can be arranged in the cavity 140, thereby being embedded in the multi-layer component carrier 100.

**Figure 5** illustrates a method of manufacturing the product 100 with fine line vias according to an illustrative example not part of the invention. Specifically, Ti/Cu sputtering is used only in the vias, while a Cu layer (no Ti) is sputtered on top of the dielectric material to form a fine line conductive fine lines. At the end, the Ti will remain in the vias and no Ti etching step required for the formation of the fine line.

Figure 5a: an electrically insulating layer structure 102 is laminated onto a core layer structure 103 (e.g. cured resin such as FR4).

Figure 5b: the glass barrier layer 150 is formed on the electrically insulating layer structure 102 by plasma coating (cold atmospheric pressure plasma).

Figure 5c: a protection layer 170 (e.g. a protective foil) is laminated on top of the glass barrier layer 150.

Figure 5d: blind holes 171 are formed through the protection layer 170, the glass barrier layer 150, and the electrically insulating layer structure 102, e.g. by laser drilling.

Figure 5e: a (electrically conductive) seed layer 175 is formed on top of the protection layer 170 and on the sidewalls and the bottoms of the blind holes 171. The seed layer 175 is provided by Ti/Cu sputtering.

Figure 5f: the protection layer 170 and part of the Ti/Cu seed layer 175 have been removed, so that the Ti/Cu seed layer 175 only remains in the blind holes 171.

Figure 5g: a further (electrically conductive) seed layer 175, being a Cu seed layer, is formed on the glass barrier layer 150 and the sidewalls, and the bottoms of the blind holes 171.

Figure 5h: holes for electrically conductive (metal) traces 185 are formed on the Cu seed layer 175 using a photo resist layer 186 (resist lamination, exposure, development).

Figure 5i: the blind holes 171 are filled by metal (copper) using plating. Further, using the same plating process, the holes 185 are also filled by the metal to obtain fine pattern metal traces.

Figure 5j: the photo resist 186 is stripped, leaving the metal traces 185 exposed. A further step of copper etching (not titanium etching) can be performed.

Figure 5k: the final product 100 is obtained with a plurality of glass barrier layers 150 and fine pattern metal traces 185. Titanium is only present at the via bottoms and sidewalls, but not around the glass barrier layer 150.

### Reference signs

- 100: Product, component carrier
- 102: Electrically insulating layer structure
- 103: Core layer structure
- 104: Electrically conductive layer structure
- 120: Blind hole
- 121: Through hole
- 122: Hole bottom
- 125: Seed layer
- 126: Via filling, electrically conductive material
- 130: Photo film
- 131: Pattern
- 132: Electrically conductive trace
- 140: Cavity, embedded component
- 150: Glass barrier layer
- 150a: First main surface
- 150b: Second main surface
- 151: First layer
- 152: Second layer
- 155: Further glass barrier layer
- 160: Particles
- 170: Protection layer
- 171: Via hole
- 175: Ti/Cu seed layer
- 180: Cu seed layer
- 185: Fine pattern hole/trace
- 186: Photo resist
- 190: Plated copper

## Claims

1. A multi-layer component carrier (100), comprising:
a plurality of electrically insulating layer structures (102);
a plurality of electrically conductive layer structures (104);
at least one glass barrier layer (150), at least partially sandwiched between one of the plurality of electrically insulating layer structures (102) and one of the plurality of electrically conductive layer structures (104);
wherein the at least one glass barrier layer (150) comprises two main surfaces (150a, 150b), said two main surfaces (150a, 150b) comprising a different adhesion property;
wherein the at least one glass barrier layer (150) comprises:
a first layer (151) being in direct contact with one of the plurality of electrically conductive layer structures (104); and
a second layer (152) being in direct contact with one of the plurality of electrically insulating layer structure (102);
wherein one of the two main surfaces (150a) of the at least one glass barrier layer (150) comprises at least one functional group for providing hydrophilic properties; and
wherein the other one of the two main surfaces (150b) of the at least one glass barrier layer (150) comprises at least one functional group for providing the hydrophobic properties.

2. The multi-layer component carrier (100) according to claim 1,
wherein the at least one glass barrier layer (150) comprises a thickness in the range 10 to 600 nm, in particular 50 nm to 350 nm.

3. The multi-layer component carrier (100) according to any one of the preceding claims,
wherein the electrically conductive layer structure (104) comprises at least one smooth surface, in particular with a surface roughness Ra of 150 nm or smaller, more in particular 100 nm or smaller.

4. The multi-layer component carrier (100) according to any one of the preceding claims,
wherein the main surface (150a) of the at least one glass barrier layer (150) comprising at least one functional group for providing the hydrophilic properties comprises one of the following functional groups: imine, amine, thiol, thioamide, phosphate, hydroxyl, thiazole, imidazole, acrylate, methacrylate, an alcohol group, in particular 3-hydroxypropyl or 2-hydroxyethyl.

5. The multi-layer component carrier (100) according to any one of the preceding claims,
wherein the main surface (150b) of the at least one glass barrier layer (150) comprising at least one functional group for providing the hydrophobic properties comprises one of the following functional groups: epoxy, allyl, amine, vinyl, alkyl, anhydride, in particular maleic anhydride, furane, pyrrole, thiophene, and/or a cyclic unsaturated alkene, in particular cyclic pentene.

6. The product (100) according to any one of the preceding claims,
wherein the at least one glass barrier layer (150) comprises silicon dioxide, SiO₂.

7. The multi-layer component carrier (100) according to any one of the preceding claims,
comprising an adhesion between the electrically conductive layer structure (104) and the at least one glass barrier layer (150), of 40 N/m or more, in particular 400 N/m or more, more in particular 500 N/m or more.

8. The multi-layer component carrier (100) according to any one of the preceding claims, further comprising
at least two glass barrier layers (150, 155),
in particular wherein the at least two glass barrier layers (150, 155) are at least partially in contact to each other,
more in particular wherein the portions that are in contact of the at least two glass barrier layers (150, 155) comprise the same adhesion properties.

9. A method of manufacturing a multi-layer component carrier, comprising:
forming a plurality of electrically insulating layer structures (102);
forming a plurality of electrically conductive layer structures (104); and
forming at least one glass barrier layer (150) in between one of the plurality of electrically insulating layer structures (102) and one of the plurality of electrically conductive layer structures (104);
wherein the at least one glass barrier layer (150) comprises two main surfaces (150a, 150b), said two main surfaces (150a, 150b) comprising a different adhesion property;
wherein the at least one glass barrier layer (150) comprises:
a first layer (151) being in direct contact with one of the plurality of electrically conductive layer structures (104); and
a second layer (152) being in direct contact with one of the plurality of electrically insulating layer structures (102)
wherein one of the two main surfaces (150a) of the at least one glass barrier layer (150) comprises at least one functional group for providing hydrophilic properties; and
wherein the other one of the two main surfaces (150b) of the at least one glass barrier layer (150) comprises at least one functional group for providing the hydrophobic properties.

10. The method according to claim 9, wherein forming the glass barrier layer (150) further comprises:
depositing the glass barrier layer (150), in particular on the electrically conductive layer structure (104), by a plasma process, in particular an atmospheric pressure plasma process; and/or
providing a glass barrier layer preform that comprises at least one silane and/or siloxane compound, and performing a plasma process, thereby partially oxidizing the glass barrier layer preform to form silicon dioxide from at least part of the silane and/or siloxane compounds, to form the glass barrier layer (150).

11. Using a glass barrier layer (150) for a multi-layer component carrier (100), wherein two main surfaces (150a, 150b) comprise a different adhesion property, between an electrically insulating layer structure (102) and an electrically conductive layer structure (104) of the multi-layer component carrier (100) as a barrier and adhesion promoter, wherein
one of the two main surfaces (150a) of the at least one glass barrier layer (150) comprises at least one functional group for providing hydrophilic properties and the other one of the two main surfaces (150b) of the at least one glass barrier layer (150) comprises at least one functional group for providing the hydrophobic properties.

## Patentansprüche

1. Mehrschichtiger Komponententräger (100), umfassend:
eine Vielzahl von elektrisch isolierenden Schichtstrukturen (102);
eine Vielzahl von elektrisch leitenden Schichtstrukturen (104);
mindestens eine Glasbarriereschicht (150), die zumindest teilweise sandwichartig zwischen einer der Vielzahl von elektrisch isolierenden Schichtstrukturen (102) und einer der Vielzahl von elektrisch leitenden Schichtstrukturen (104) angeordnet ist;
wobei die mindestens eine Glasbarriereschicht (150) zwei Hauptflächen (150a, 150b) umfasst, wobei die zwei Hauptflächen (150a, 150b) eine unterschiedliche Haftungseigenschaft aufweisen;
wobei die mindestens eine Glasbarriereschicht (150) Folgendes umfasst:
eine erste Schicht (151), die in direktem Kontakt mit einer der Vielzahl von elektrisch leitenden Schichtstrukturen (104) steht; und
eine zweite Schicht (152), die in direktem Kontakt mit einer der Vielzahl von elektrisch isolierenden Schichtstrukturen (102) steht;
wobei eine der zwei Hauptflächen (150a) der mindestens einen Glasbarriereschicht (150) mindestens eine funktionelle Gruppe zum Bereitstellen hydrophiler Eigenschaften umfasst; und
wobei die andere der zwei Hauptflächen (150b) der mindestens einen Glasbarriereschicht (150) mindestens eine funktionelle Gruppe zum Bereitstellen der hydrophoben Eigenschaften umfasst.

2. Mehrschichtiger Komponententräger (100) nach Anspruch 1,
wobei die mindestens eine Glasbarriereschicht (150) eine Dicke im Bereich 10 bis 600 nm, insbesondere 50 nm bis 350 nm, aufweist.

3. Mehrschichtiger Komponententräger (100) nach einem der vorhergehenden Ansprüche,
wobei die elektrisch leitende Schichtstruktur (104) mindestens eine glatte Oberfläche, insbesondere mit einer Oberflächenrauheit Ra von 150 nm oder weniger, noch besonderer 100 nm oder weniger, umfasst.

4. Mehrschichtiger Komponententräger (100) nach einem der vorhergehenden Ansprüche,
wobei die Hauptfläche (150a) der mindestens einen Glasbarriereschicht (150), die mindestens eine funktionelle Gruppe zum Bereitstellen der hydrophilen Eigenschaften umfasst, eine der folgenden funktionellen Gruppen umfasst: Imin, Amin, Thiol, Thioamid, Phosphat, Hydroxyl, Thiazol, Imidazol, Acrylat, Methacrylat, eine Alkoholgruppe, insbesondere 3-Hydroxypropyl oder 2-Hydroxyethyl.

5. Mehrschichtiger Komponententräger (100) nach einem der vorhergehenden Ansprüche,
wobei die Hauptfläche (150b) der mindestens einen Glasbarriereschicht (150), die mindestens eine funktionelle Gruppe zum Bereitstellen der hydrophoben Eigenschaften umfasst, eine der folgenden funktionellen Gruppen umfasst: Epoxy, Allyl, Amin, Vinyl, Alkyl, Anhydrid, insbesondere Maleinsäureanhydrid, Furan, Pyrrol, Thiophen und/oder ein cyclisches ungesättigtes Alken, insbesondere cyclisches Penten.

6. Produkt (100) nach einem der vorhergehenden Ansprüche,
wobei die mindestens eine Glasbarriereschicht (150) Siliciumdioxid, SiO₂, umfasst.

7. Mehrschichtiger Komponententräger (100) nach einem der vorhergehenden Ansprüche, der eine Haftkraft zwischen der elektrisch leitenden Schichtstruktur (104) und der mindestens einen Glasbarriereschicht (150) von 40 N/m oder mehr, insbesondere 400 N/m oder mehr, noch besonderer 500 N/m oder mehr, aufweist.

8. Mehrschichtiger Komponententräger (100) nach einem der vorhergehenden Ansprüche, ferner umfassend
mindestens zwei Glasbarriereschichten (150, 155),
wobei die mindestens zwei Glasbarriereschichten (150, 155) insbesondere zumindest teilweise miteinander in Kontakt stehen,
wobei die Abschnitte, die in Kontakt mit den mindestens zwei Glasbarriereschichten (150, 155) stehen, noch besonderer die gleichen Haftungseigenschaften aufweisen.

9. Verfahren zur Herstellung eines mehrschichtigen Komponententrägers, umfassend:
Bilden einer Vielzahl von elektrisch isolierenden Schichtstrukturen (102);
Bilden einer Vielzahl von elektrisch leitenden Schichtstrukturen (104); und
Bilden mindestens einer Glasbarriereschicht (150) zwischen einer der Vielzahl von elektrisch isolierenden Schichtstrukturen (102) und einer der Vielzahl von elektrisch leitenden Schichtstrukturen (104);
wobei die mindestens eine Glasbarriereschicht (150) zwei Hauptflächen (150a, 150b) umfasst, wobei die zwei Hauptflächen (150a, 150b) eine unterschiedliche Haftungseigenschaft aufweisen;
wobei die mindestens eine Glasbarriereschicht (150) Folgendes umfasst:
eine erste Schicht (151), die in direktem Kontakt mit einer der Vielzahl von elektrisch leitenden Schichtstrukturen (104) steht; und
eine zweite Schicht (152), die in direktem Kontakt mit einer der Vielzahl von elektrisch isolierenden Schichtstrukturen (102) steht,
wobei eine der zwei Hauptflächen (150a) der mindestens einen Glasbarriereschicht (150) mindestens eine funktionelle Gruppe zum Bereitstellen hydrophiler Eigenschaften umfasst; und
wobei die andere der zwei Hauptflächen (150b) der mindestens einen Glasbarriereschicht (150) mindestens eine funktionelle Gruppe zum Bereitstellen der hydrophoben Eigenschaften umfasst.

10. Verfahren nach Anspruch 9, wobei das Bilden der Glasbarriereschicht (150) ferner Folgendes umfasst:
Abscheiden der Glasbarriereschicht (150), insbesondere auf der elektrisch leitenden Schichtstruktur (104), durch einen Plasmaprozess, insbesondere einen Atmosphärendruck-Plasmaprozess; und/oder
Bereitstellen einer Glasbarriereschicht-Vorform, die mindestens eine Silan- und/oder Siloxanverbindung umfasst, und Durchführen eines Plasmaprozesses, wodurch die Glasbarriereschicht-Vorform teilweise oxidiert wird, um Siliciumdioxid aus mindestens einem Teil der Silan- und/oder Siloxanverbindungen zu bilden, um die Glasbarriereschicht (150) zu bilden.

11. Verwendung einer Glasbarriereschicht (150) für einen mehrschichtigen Komponententräger (100), wobei zwei Hauptflächen (150a, 150b) eine unterschiedliche Haftungseigenschaft aufweisen, zwischen einer elektrisch isolierenden Schichtstruktur (102) und einer elektrisch leitenden Schichtstruktur (104) des mehrschichtigen Komponententrägers (100) als eine Barriere und einen Haftvermittler, wobei
eine der zwei Hauptflächen (150a) der mindestens einen Glasbarriereschicht (150) mindestens eine funktionelle Gruppe zum Bereitstellen hydrophiler Eigenschaften umfasst, und die andere der zwei Hauptflächen (150b) der mindestens einen Glasbarriereschicht (150) mindestens eine funktionelle Gruppe zum Bereitstellen der hydrophoben Eigenschaften umfasst.

## Revendications

1. Support de composants multicouche (100), comprenant :
une pluralité de structures de couche électro-isolante (102) ;
une pluralité de structures de couche électroconductrice (104) ;
au moins une couche barrière en verre (150), au moins partiellement intercalée entre l'une parmi la pluralité de structures de couche électro-isolante (102) et l'une parmi la pluralité de structures de couche électroconductrice (104) ;
dans lequel l'au moins une couche barrière en verre (150) comprend deux surfaces principales (150a, 150b), lesdites deux surfaces principales (150a, 150b) comprenant une propriété d'adhérence différente ;
dans lequel l'au moins une couche barrière en verre (150) comprend :
une première couche (151) qui est en contact direct avec l'une parmi la pluralité de structures de couche électroconductrice (104) ; et
une deuxième couche (152) qui est en contact direct avec l'une parmi la pluralité de structures de couche électro-isolante (102) ;
dans lequel l'une parmi les deux surfaces principales (150a) de l'au moins une couche barrière en verre (150) comprend au moins un groupe fonctionnel destiné à conférer des propriétés hydrophiles ; et
dans lequel l'autre parmi les deux surfaces principales (150b) de l'au moins une couche barrière en verre (150) comprend au moins un groupe fonctionnel destiné à conférer les propriétés hydrophobes.

2. Support de composants multicouche (100) selon la revendication 1, dans lequel l'au moins une couche barrière en verre (150) présente une épaisseur dans la plage de 10 à 600 nm, en particulier de 50 nm à 350 nm.

3. Support de composants multicouche (100) selon l'une quelconque des revendications précédentes,
dans lequel la structure de couche électroconductrice (104) comprend au moins une surface lisse, en particulier avec une rugosité de surface Ra de 150 nm ou moins, plus particulièrement 100 nm ou moins.

4. Support de composants multicouche (100) selon l'une quelconque des revendications précédentes,
dans lequel la surface principale (150a) de l'au moins une couche barrière en verre (150) comprenant au moins un groupe fonctionnel destiné à conférer les propriétés hydrophiles comprend l'un parmi les groupes fonctionnels suivants : imine, amine, thiol, thioamide, phosphate, hydroxyle, thiazole, imidazole, acrylate, méthacrylate, un groupe alcool, en particulier 3-hydroxypropyle ou 2-hydroxyéthyle.

5. Support de composants multicouche (100) selon l'une quelconque des revendications précédentes,
dans lequel la surface principale (150b) de l'au moins une couche barrière en verre (150) comprenant au moins un groupe fonctionnel destiné à conférer les propriétés hydrophobes comprend l'un parmi les groupes fonctionnels suivants : époxy, allyle, amine, vinyle, alkyle, anhydride, en particulier anhydride maléique, furane, pyrrole, thiophène, et/ou un alcène insaturé cyclique, en particulier pentène cyclique.

6. Produit (100) selon l'une quelconque des revendications précédentes, dans lequel l'au moins une couche barrière en verre (150) comprend du dioxyde de silicium, SiO₂.

7. Support de composants multicouche (100) selon l'une quelconque des revendications précédentes, comprenant une adhérence entre la structure de couche électroconductrice (104) et l'au moins une couche barrière en verre (150), de 40 N/m ou plus, en particulier de 400 N/m ou plus, plus particulièrement de 500 N/m ou plus.

8. Support de composants multicouche (100) selon l'une quelconque des revendications précédentes, comprenant en outre
au moins deux couches barrières en verre (150, 155),
en particulier, dans lequel les au moins deux couches barrières en verre (150, 155) sont au moins partiellement en contact l'une avec l'autre, plus particulièrement, dans lequel les portions en contact des au moins deux couches barrières en verre (150, 155) présentant les mêmes propriétés d'adhérence.

9. Procédé de fabrication d'un support de composants multicouche, comprenant :
la formation d'une pluralité de structures de couche électro-isolante (102) ;
la formation d'une pluralité de structures de couche électroconductrice (104) ; et
la formation d'au moins une couche barrière en verre (150) entre l'une parmi la pluralité de structures de couche électro-isolante (102) et l'une parmi la pluralité de structures de couche électroconductrice (104) ;
dans lequel l'au moins une couche barrière en verre (150) comprend deux surfaces principales (150a, 150b), lesdites deux surfaces principales (150a, 150b) comprenant une propriété d'adhérence différente ;
dans lequel l'au moins une couche barrière en verre (150) comprend :
une première couche (151) qui est en contact direct avec l'une parmi la pluralité de structures de couche électroconductrice (104) ; et
une deuxième couche (152) qui est en contact direct avec l'une parmi la pluralité de structures de couche électro-isolante (102)
dans lequel l'une parmi les deux surfaces principales (150a) de l'au moins une couche barrière en verre (150) comprend au moins un groupe fonctionnel destiné à conférer des propriétés hydrophiles ; et
dans lequel l'autre parmi les deux surfaces principales (150b) de l'au moins une couche barrière en verre (150) comprend au moins un groupe fonctionnel destiné à conférer les propriétés hydrophobes.

10. Procédé selon la revendication 9, dans lequel la formation de la couche barrière en verre (150) comprend en outre :
le dépôt de la couche barrière en verre (150), en particulier sur la structure de couche électroconductrice (104), par un processus au plasma, en particulier un processus au plasma à pression atmosphérique ; et/ou
la fourniture d'une préforme de couche barrière en verre qui comprend au moins un composé silane et/ou siloxane, et la réalisation d'un processus au plasma, oxydant ainsi partiellement la préforme de couche barrière en verre pour former du dioxyde de silicium à partir d'au moins une partie des composés silane et/ou siloxane, pour former la couche barrière en verre (150).

11. Utilisation d'une couche barrière en verre (150) pour un support de composants multicouche (100), dans laquelle deux surfaces principales (150a, 150b) présentent une propriété d'adhérence différente, entre une structure de couche électro-isolante (102) et une structure de couche électroconductrice (104) du support de composants multicouche (100) en tant que barrière et promoteur d'adhésion, dans laquelle
l'une parmi les deux surfaces principales (150a) de l'au moins une couche barrière en verre (150) comprend au moins un groupe fonctionnel destiné à conférer des propriétés hydrophiles et l'autre parmi les deux surfaces principales (150b) de l'au moins une couche barrière en verre (150) comprend au moins un groupe fonctionnel destiné à conférer les propriétés hydrophobes.
